(19) Europäisches Patentamt
European Patent Office
Office européen des brevets

(11) **EP 2 829 886 B1**

(12) **EUROPEAN PATENT SPECIFICATION**

(45) Date of publication and mention
of the grant of the patent:
**02.06.2021 Bulletin 2021/22**

(21) Application number: **14160477.7**

(22) Date of filing: **18.03.2014**

(51) Int Cl.:
*B60L 15/00* (2006.01)          *B60L 15/20* (2006.01)
*B60L 50/51* (2019.01)          *G01R 31/58* (2020.01)
*G01R 31/66* (2020.01)          *H02H 3/13* (2006.01)
*G01R 31/42* (2006.01)          *H02P 27/08* (2006.01)
*B60L 3/00* (2019.01)          *B60L 53/16* (2019.01)
*H02P 29/024* (2016.01)

(54) **Inverter system and method of detecting state of power cable of the inverter system**

Wechselrichtersystem und Verfahren zur Detektion des Stromkabelzustands des
Wechselrichtersystems

Système d'onduleur et procédé de détection d'état de câble de puissance dudit système

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **03.06.2013 KR 20130063615**

(43) Date of publication of application:
**28.01.2015 Bulletin 2015/05**

(73) Proprietor: **LSIS Co., Ltd.
Dongan-gu, Anyang-si
Gyeonggi-do 431-080 (KR)**

(72) Inventor: **Choi, Gi Young
431-080 Anyang-si, Gyeonggi-do (KR)**

(74) Representative: **K&L Gates LLP
Karolinen Karree
Karlstraße 12
80333 München (DE)**

(56) References cited:
**JP-A- H06 245 301     US-A1- 2012 068 721**

**Description**

## BACKGROUND

The present disclosure relates to an inverter, and more particularly, to a method of detecting a disconnection of a high voltage cable included in the inverter.

Inverter systems, which are motor controllers used in eco-friendly vehicles, etc., are electric/electronic sub assembly (ESA) converting a high voltage direct current (DC) power into an alternating current (AC) or a DC power and are primary components included in electric motors of vehicles.

As described above, eco-friendly vehicles employ permanent magnet type motors as driving units. Motors applied as driving units to eco-friendly vehicles are driven by phase currents transferred through a first high voltage power cable from an inverter converting a DC current into a three-phase voltage according to a pulse width modulation (PWM) signal of a controller.

Also, the inverter converts a DC link voltage transferred through a second high voltage power cable by opening and closing of a main relay into a three-phase voltage.

Accordingly, when any one of the first power cable connecting the inverter to the motor and the second power cable connecting a high voltage battery to the inverter is separated, the motor is not smoothly driven and a high voltage/high current is left to an inverter system, thereby causing a fatal error damaging the entire inverter system.

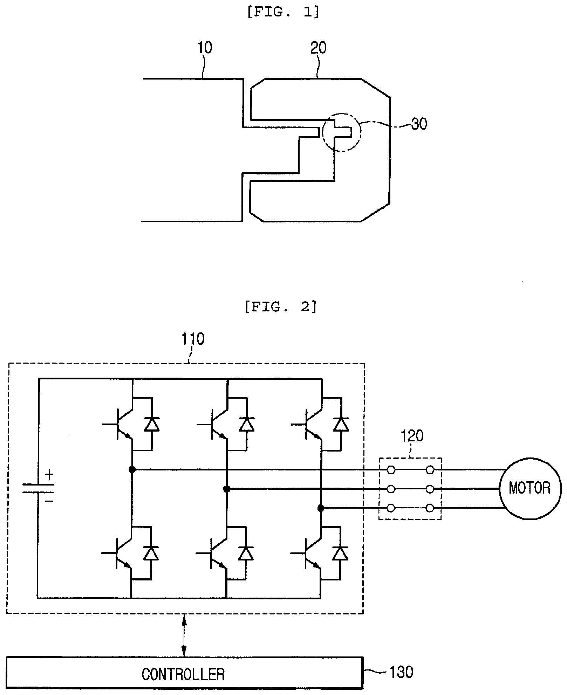

FIG. 1 is a diagram of a general apparatus for detecting a separation of a power cable in an inverter system.

Referring to FIG. 1, the apparatus includes a power cable 10, a connector 20, and a sensor 30 formed between the power cable 10 and the connector 20 and transmitting a signal according to a separation between the power cable 10 and the connector 20.

The sensor 30 is connected to a contact portion between the power cable 10 and the connector 20 and transmits a digital signal according to whether the power cable 10 is connected to the connector 20 to a controller.

That is, in general, a sensor for checking whether the power cable 10 is separated is additionally installed in an aspect of hardware in one of the power cable 10 and the connector 20. It is checked using a digital signal outputted from the sensor in real time whether the power cable 10 is separated.

However, since the apparatus for detecting the separation of the power cable only detects whether the power cable is separated in the aspect of hardware, there are limitations in price and space.

Also, the apparatus for detecting the separation of the power cable may easily misoperate due to an external cause such as vibrations, etc., which causes a danger in safety of a driver.

Document JP H06 245301 discloses a method for detecting in an inverter system an open phase based on the average current in each phase during a mobile window.

## SUMMARY

Embodiments provide a method of detecting a separation of a power cable in an inverter system capable of detecting whether a power cable is separated in an aspect of software without additional hardware.

Embodiments also provide a method of detecting a separation of a power cable in a system mounted with hardware capable of detecting the separation of the power cable to check whether the hardware normally operates.

Additional aspects will be set forth in part in the description which follows and, in part, will be apparent from the description, or may be learned by practice of the presented embodiments.

In one embodiment, a method of detecting a state of a power cable included in an inverter system includes obtaining a value of a phase current supplied to a motor through the power cable according to a preset period, generating a mobile window having a certain size with respect to a phase-current value obtained for each period and obtaining a mobile window operation value by using the phase-current value included in the generated mobile window, comparing the obtained mobile window operation value with a preset reference value, and detecting whether the power cable is abnormal, according to a result of the comparing.

The method may further include calculating an absolute value of the obtained phase-current value, in which the mobile window operation value may be operated by using the calculated absolute value.

The mobile window operation value may be any one of a total sum of absolute values included in the mobile window having the certain size, an integral value of the absolute values included in the mobile window having the certain size, a mean value of the absolute values included in the mobile window having the certain size, and a total sum of the absolute values included in the mobile window having the certain size, the absolute values being added with a preset weighted factor.

The power cable may be a three-phase power cable. In this case, the obtaining of the phase-current value may include obtaining an a-phase current value, a b-phase current value, and a c-current value with respect to three phases, respectively, and the detecting of whether the power cable is abnormal may include detecting whether an a-phase power cable, a b-phase power cable, and a c-phase cable included in the three-phase power cable are abnormal, respectively.

The detecting of whether the power cable is abnormal may include detecting that the power cable is normal when the obtained mobile window operation value is the preset reference value or more and detecting that the power cable is abnormal when the obtained mobile window operation value is smaller than the preset reference value.

The method may further include determining whether a present state of the inverter system satisfies preset preconditions, in which the detecting of whether the power cable is abnormal may be performed when the present state of the inverter system satisfies the preset preconditions, and preconditions may include any one of a condition, in which the period of the phase current is a certain value or less, a condition, in which an inverter operates according to a gear stage for performing a pulse width modulation (PWM) control, and a condition, in which an instruction including at least one of torque, velocity, and currents is a certain value or more.

The method may further include, when the mobile window operation value is obtained, moving a location of the mobile window to the right with a certain interval and obtaining a mobile window operation value of the moved mobile window.

In another embodiment, an inverter system includes an inverter converting a direct current (DC) power supplied from a battery into an alternating current (AC) power, a power cable connected to the inverter and supplying the AC power to a motor, and a controller obtaining an absolute value of a phase-current value with respect to the AC power supplied to the motor for each period, obtaining a mobile window operation value by using absolute values included in a mobile window having a certain size among the absolute values obtained at every certain period, and detecting a state of the power cable by using the obtained mobile window operation value.

The mobile window operation value may be any one of a total sum of absolute values included in the mobile window having the certain size, an integral value of the absolute values included in the mobile window having the certain size, a mean value of the absolute values included in the mobile window having the certain size, and a total sum of the absolute values included in the mobile window having the certain size, the absolute values being added with a preset weighted factor.

The power cable may be a three-phase power cable. In this case, the phase-current value may include an a-phase current value, a b-phase current value, and a c-current value with respect to three phases, respectively, and the controller may detect whether an a-phase power cable, a b-phase power cable, and a c-phase cable included in the three-phase power cable are abnormal, respectively.

The controller may detect that the power cable is normal when the obtained mobile window operation value is the preset reference value or more. The controller may detect that the power cable is abnormal when the obtained mobile window operation value is smaller than the preset reference value.

The controller may detect whether the power cable is abnormal when satisfying any one of a condition, in which the period of the phase current is a certain value or less, a condition, in which an inverter operates according to a gear stage for performing a pulse width modulation (PWM) control, and a case, in which an instruction including at least one of torque, velocity, and currents is a certain value or more.

The controller, when the mobile window operation value is obtained, may move a location of the mobile window to the right with a certain interval and may obtain a mobile window operation value of the moved mobile window.

The details of one or more embodiments are set forth in the accompanying drawings and the description below. Other features will be apparent from the description and drawings, and from the claims.

## BRIEF DESCRIPTION OF THE DRAWINGS

FIG. 1 is a diagram of a prior art apparatus for detecting a separation of a power cable in an inverter system.

FIG. 2 is a configuration diagram of an inverter system according to an embodiment;

FIG. 3 is a diagram illustrating components for detecting a separation of a power cable 120 from a controller 130 shown in FIG. 2;

FIGS. 4 and 5 are diagrams illustrating a process of obtaining a mobile window operation value according to an embodiment; and

FIGS. 6 and 7 are flowcharts illustrating operations of a method of detecting a state of a power cable in an inverter system according to embodiments.

## DETAILED DESCRIPTION OF THE EMBODIMENTS

Hereinafter, a theory of embodiments will be described. Accordingly, one of ordinary skill in the art, although not being clearly described or shown in the specification, may made various apparatuses embodying the theory and included in the concepts and scope of the embodiments. Also, all conditional terms and embodiments described herein are described basically to allow the concepts of the embodiments to be clearly understood but do not limit the same.

Also, not only the theory, views, and embodiments, but also all detailed descriptions of particular embodiments should be understood to include structural and functional equivalents thereof. Also, it will be understood that the equivalents include not only presently known equivalents but also equivalents developable in the future, that is, all devices made to perform identical functions regardless of structures thereof.

FIG. 2 is a configuration diagram of an inverter system according to an embodiment.

Referring to FIG. 2, the inverter system includes an inverter 110, a three-phase power cable 120 supplying power outputted through the inverter 110 to a motor, and a controller 130 detecting whether the three-phase power cable 120 is separated and stopping the operations of the inverter 110 while controlling operations of the inverter 110.

The inverter 110 is formed in an electric automobile and then converts direct current (DC) power generated by a battery (not shown) formed in the electric automobile into a three-phase alternating current (AC) power.

In this case, the battery may be formed of a set of a plurality of unit cells.

The plurality of unit cells may be managed by a battery management system (not shown) to maintain a certain voltage. The battery may discharge the certain voltage under the control of the battery management system.

Also, the power outputted by the discharging of the battery is transferred to a capacitor formed in the inverter 110.

In this case, a relay is formed between the battery and the inverter 110 and power supplied to the inverter 110 may be controlled by operations of the relay.

That is, when the relay performs an operation of "on", the power of the battery is supplied to the inverter 110 and when the relay performs an operation of "off", the power supplied to the inverter 110 may be cut off.

The inverter 110 converts a DC power supplied from the battery into an AC power and supplies the AC power to the motor.

In this case, the AC power converted by the inverter 110 may be a three-phase AC power.

The inverter 110 is formed of the capacitor and a plurality of insulated gate bipolar transistor (IGBT). The IGBT converts a phase of the power supplied from the battery by pulse width modulation (PWM) switching according to a control signal applied from the controller 130 and supplies the phase-converted power to the motor.

The motor may include a stator not rotating and fixed and a rotator that rotates. The motor receives AC power supplied through the inverter 110.

The motor, for example, may be a three-phase motor. When respective phase AC powers having variable voltages and frequencies are applied to coils of stators of respective phases, a rotation speed of the rotator may vary with the applied frequency.

The motor may be various such as an induction motor, a blushless DC (BLDC) motor, and a reluctance motor.

On the other hand, a driving gear (not shown) may be provided on one side of the motor. The driving gear converts rotational energy of the motor according to a gear ratio. The rotational energy outputted from the driving gear is transmitted to a front wheel and/or a rear wheel to allow the electric automobile to move.

The power cable 120 is formed between the inverter 110 and the motor. The power cable 120 may be a three-phase power cable, and accordingly, is formed of an a-phase cable, a b-phase cable, and a c-phase cable.

The controller 130 controls overall operations of the inverter 110.

For example, the controller 130 calculates a driving value for driving the motor by using a current, for example, a three-phase current supplied to the motor and generates a switching signal for controlling the inverter 110, particularly, the switching of the IGBTs forming the inverter 110 according to the calculated driving value.

Accordingly, the inverter 110 converts the DC power supplied form the battery into AC power by selectively performing on-off operations according to the switching signal generated through the controller 130.

On the other hand, the controller 130 checks a state of the power cable 120 connecting the inverter 110 and the motor by determining a state of the three-phase current supplied from the inverter 110 to the motor.

Also, when a problem occurs in the state of the power cable 120, such as a disconnection, a separation, etc., the AC power converted through the inverter 110 is not supplied to the motor, thereby generating a problem in driving the electric automobile.

According thereto, the controller 130 detects whether the power cable 120 is separated and cuts off the AC power supplied to the motor when it is detected that the power cable 120 is separated.

Hereinafter, an operation of detecting a separation of the power cable 120, performed by the controller 130, will be described in detail.

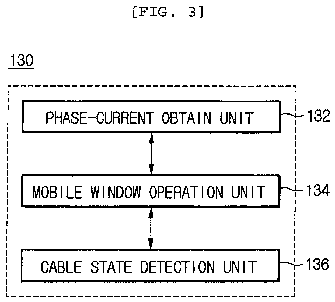

FIG. 3 is a diagram illustrating components for detecting the separation of the power cable 120 from the controller 130 shown in FIG. 2.

Referring to FIG. 3, the controller 130 includes a phase-current obtain unit 132, a mobile window operation unit 134, and a cable state detection unit 136.

The phase-current obtain unit 132 obtains a phase current supplied from the inverter 110 to the motor.

In this case, the phase-current obtain unit 132 obtains an a-phase current Ias supplied to the motor through the a-phase cable of the power cable 120, a b-phase current Ibs supplied to the motor through the b-phase cable of the power cable 120, and a c-phase current Ics supplied to the motor through the c-phase cable of the power cable 120, respectively.

After that, the phase-current obtain unit 132 calculates absolute values |Ias|, |Ibs|, and |Ics| with respect to the a-phase current Ias, the b-phase current Ibs, and the c-phase current Ics, respectively.

After that, the phase-current obtain unit 132 calculates and transmits the absolute values |Ias|, |Ibs|, and |Ics| with respect to the a-phase current Ias, the b-phase current Ibs, and the c-phase current Ics to the mobile window operation unit 134 for each preset certain time Tsamp.

The mobile window operation unit 134 generates mobile windows having certain sizes with respect to the absolute values |Ias|, |Ibs|, and |Ics| transmitted through the phase-current obtain unit 132 and obtains mobile window operation values MW |Ias|, MW |Ibs|, and MW |Ics| in the generated mobile windows.

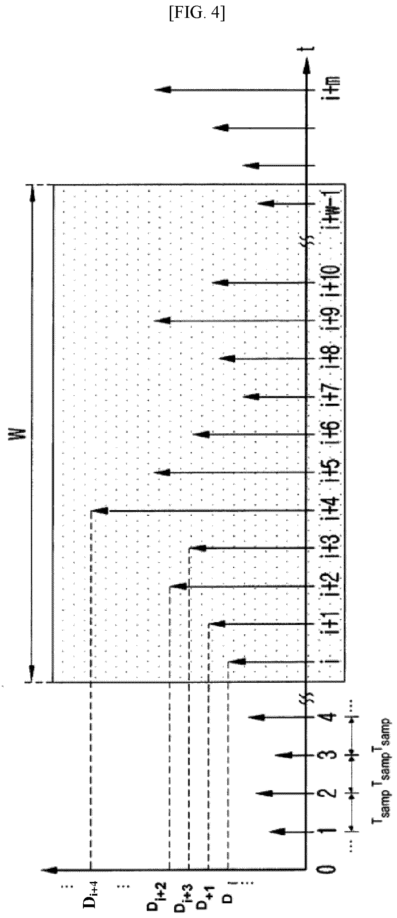

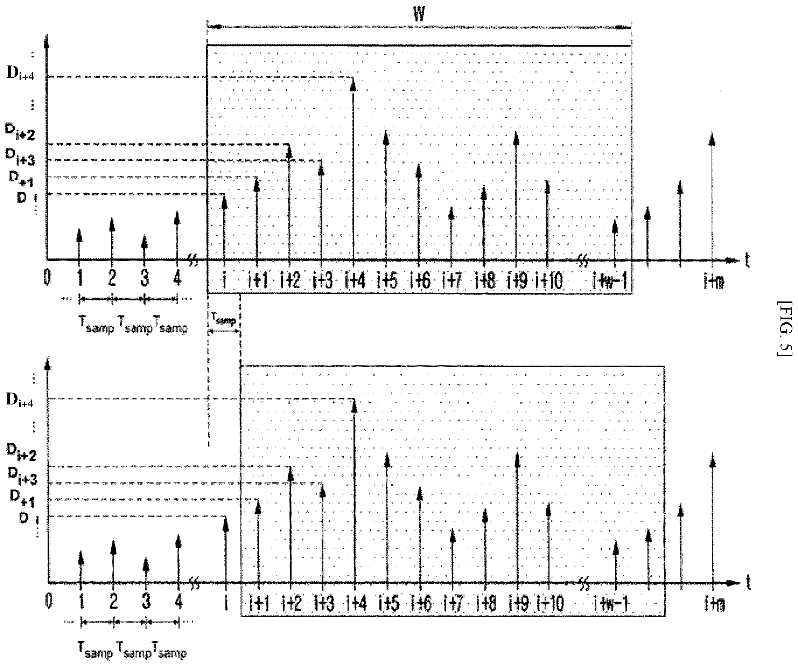

FIGS. 4 and 5 are diagrams illustrating a process of obtaining a mobile window operation value according to an embodiment.

Referring to FIG. 4, a horizontal axis indicates a time axis and a vertical axis indicates an absolute value obtained at every certain time Tsamp. FIG. 4 illustrates an absolute value with respect to a certain phase of any one of the absolute values |Ias|, |Ibs|, and |Ics|.

The phase-current obtain unit 132 obtains and transmits the absolute value described above to the mobile window operation unit 134 for each certain time.

The mobile window operation unit 134 obtains mobile window operation values using values included in a window w having a certain size with respect to the obtained absolute value.

In this case, the mobile window operation value may be obtained using any one of following equations.

$$D_{sum} = \sum_{n=i}^{i+w-1} D_n \qquad \cdots \text{Equation (1)}$$

Equation 1 indicates a total sum of w number of sequential absolute values in a window whose size is w.

$$D_{integ} = T_{samp} \cdot D_{sum} \qquad \cdots \text{Equation (2)}$$

Equation 2 indicates integration within a section w, which is a result value of multiplying a result value obtained by Equation 1 by the certain time Tsamp.

$$D_{average} = D_{sum}/w \qquad \cdots \text{Equation (3)}$$

In Equation 3, the result value obtained according to Equation 1 is divided by w, in which w indicates the number of absolute values included in the window and a result value obtained according thereto indicates a mean value of the absolute values in the window.

$$D_{weighted} = \sum_{n=i}^{i+w-1} a_n \cdot D_n \qquad \cdots \text{Equation (4)}$$

Equation 4 indicates a value obtained by multiplying each absolute value included in the window by a preset weighted factor an, which indicates a total sum of absolute values added with the weighted factor in the window considering several different factors.

As mentioned in Equations 1 to 4, the mobile window operation unit 134 operates any one of the total sum of the absolute values, the mean value of the absolute values, the integral value of the absolute values, and the total sum of the absolute values added with the weighted factor by using the absolute values included in the window having the preset size as described above.

The result value obtained by the operating of the mobile window operation unit 14 may be determined according to a preset condition. That is, through various experiments in advance, the result value that will be operated by determining optimum conditions according to an operation state of the inverter 110.

For example, at a point in time that the inverter 110 initially operates, the mobile window operation value may be obtained by using the mean value mentioned in Equation 3. At a point in time that the inverter 110 stabilizes, the mobile window operation value may be obtained by using any one of Equations 1 to 4.

The cable state detection unit 136 detects the state of the power cable 120 by using the mobile window operation value obtained by the mobile window operation unit 134.

That is, the cable state detection unit 136 determines a reference value of a mobile window operation value shown in a state, in which the power cable 120 is normally connected and compares the reference value with the mobile window operation value obtained by the mobile window operation unit 134, thereby detecting the state of the power cable 120.

The reference value may include a first reference value with respect to the mobile window operation value obtained according to Equation 1, a second reference value with respect to the mobile window operation value obtained according to Equation 2, a third reference value with respect to the mobile window operation value obtained according to Equation 3, and a fourth reference value with respect to the mobile window operation value obtained according to Equation 4.

Also, the first to fourth reference values may exist to correspond to the a-phase cable, the b-phase cable, and the c-phase cable, respectively.

According thereto, the reference value may exist as shown in a following table, which may be stored in the controller 130 or may be obtained by an additional operation process performed by the controller 130.

[Table 1]

|  | a phase | b phase | c phase |
|---|---|---|---|
| Equation 1 | 1-1 reference value | 1-2 reference value | 1-3 reference value |
| Equation 2 | 2-1 reference value | 2-2 reference value | 2-3 reference value |
| Equation 3 | 3-1 reference value | 3-2 reference value | 3-3 reference value |
| Equation 4 | 4-1 reference value | 4-2 reference value | 4-3 reference value |

As a result, when the first to third mobile window operation values corresponding to an a phase, a b phase, and a c phase are operated according to Equation 1, respectively, the cable state detection unit 136 detects a state of the power cable 120 with respect to the a phase by comparing the first mobile window operation value with a 1-1 reference value and similarly thereto, states of the power cable 120 with respect to the b phase and the c phase, respectively.

In the method of detecting the state, when the obtained mobile window operation value is the reference value or more, it is determined that the power cable 120 is normally connected. Differently, when the mobile window operation value is smaller than the reference value, the power cable 120 is abnormally connected, for example, a separation, a disconnection, etc.

On the other hand, the cable state detection unit 135 determines preconditions previously set to prevent wrongly detecting a connection state of the power cable 120 and detects the connection state of the power cable 120 when present conditions satisfy all the preconditions.

In this case, the preconditions may include conditions as follows:

1. Is a period of a phase current a certain value or less?
2. In case of an inverter for an electric automobile, is a certain gear stage, in which the inverter performs switching operation according to a pulse width modulation (PWM) signal?
3. Is an instruction such as torque, velocity, and currents a certain value or more?

A reciprocal number of a period of the phase current is proportional to a driving velocity of the motor. That is, the condition whether the period of the phase current is the certain value or less indicates whether the driving velocity of the motor is a preset velocity or more.

According thereto, the cable state detection unit 136 performs detecting the power cable when the period of the phase current is the certain value or less, in other words, only when the driving velocity of the motor is a certain value or more.

Also, in case of the electric automobile, the operation of the inverter 110 is determined according to a gear status. That is, when the gear state is R, D, and P, the operation of the inverter 110 is controlled according to the PWM signal. According thereto, the cable state detection unit 136 performs detecting the power cable 120 only when the gear state allows the inverter 110 to be controlled according to the PWM signal.

Also, when the instruction is the certain value or less, the detecting of the power cable 120 is not normally performed and may be wrongly performed. Accordingly, the cable state detection unit 136 detects the state of the power cable 20 only when the instruction such as torque, velocity, and currents are certain values or more.

On the other hand, as described above, when a mobile window operation value is primarily obtained, the mobile window operation unit 134 obtains second to nth mobile window operation values by using absolute values continuously provided by the phase-current obtain unit 132.

Referring to FIG. 5, when a first mobile window operation value is obtained, a location of a window is moved to the right as Tsamp. When mobile window operation values are obtained according to Equations 1 to 4 by using absolute values included in the moved window. The power cable detection unit 135 detects a state of the power cable 120 by using the mobile window operation values continuously obtained.

According to the embodiment, since it is possible to detect a disconnection of the power cable 120 in an aspect of software in real time, it is possible not only to provide advantageous effects in an aspect of price but also to prevent malfunctions that may occur due to external causes, thereby improving safety of a driver.

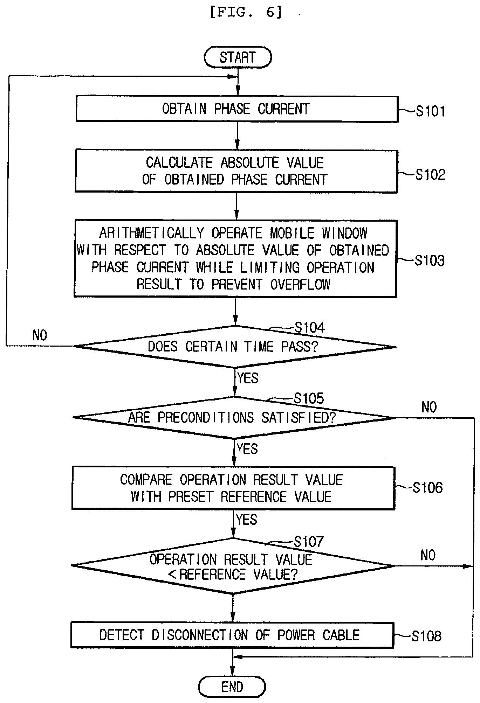

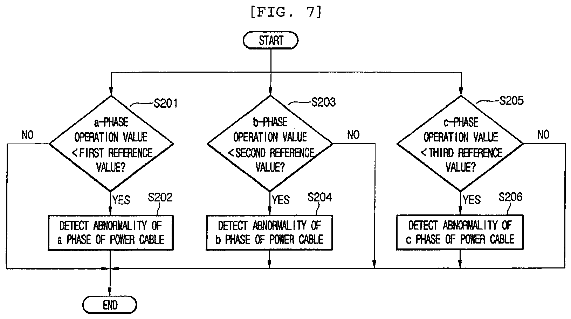

FIGS. 6 and 7 are flowcharts illustrating operations of a method of detecting a state of a power cable in an inverter system according to embodiments.

Referring to FIG. 6, the phase-current obtain unit 132 obtains a phase-current value supplied to the motor (S101). That is, the phase-current obtain unit 132 obtains a current value with respect to an a phase, a current value with respect to a b phase, and a current value with respect to a c phase, respectively.

After that, the phase-current obtain unit 132 calculates absolute values of the current values with respect to the respective obtained phases (S102). The calculated absolute values of the respect phases are transmitted to the mobile window operation unit 134.

The mobile window operation unit 134 obtains mobile window operation values with respect to the respective phases by using the absolute values with respect to the respect to the respective phases (S103).

Since the method of obtaining mobile window operation values has been described with reference to Equations 1 to 4, a detailed description thereof will be omitted.

When a mobile window operation value is obtained according to any one of Equations 1 to 4, the mobile window operation unit 134 limits a maximum value of the obtained mobile window operation value to prevent an overflow.

After that, the mobile window operation unit 134 determines whether a certain time passes (S104). That is, the mobile window operation unit 134 determines whether all absolute values corresponding to window sizes are obtained and mobile window operation values corresponding thereto are obtained.

As a result of the determining (S104), when the certain does not pass, the mobile window operation unit 134 stands by for a certain time and returns to operation (S101). When the certain time passes, the mobile window operation unit 134 determines whether preconditions for detecting a state of the power cable 120 are satisfied (S105).

That is, the mobile window operation unit 134 determines whether a period of a phase current is a certain value or less, whether an inverter for an electric automobile is on a certain gear stage switching according to a PWM signal, or whether an instruction such as torque, velocity, and currents is a certain value or more.

In this case, the mobile window operation unit 134 may determine as satisfying the preconditions when any one of conditions described above is satisfied. Differently, when a plurality of ones of the conditions are satisfied, the mobile window operation unit 134 may determine as satisfying the preconditions.

After that, when the preconditions are satisfied, the cable state detection unit 136 compares a result value of the arithmetic operation with a preset reference value (S106).

Sequentially, as a result of the comparing, it is determined whether an operation result value is smaller than the preset reference value (S107).

As a result of the determining of operation S107, when the operation result value is smaller than the preset reference value, the state of the power cable 120 is determined to be abnormal (S108).

To describe the operations S106, S107, and S108 in detail with reference to FIG. 7, the cable state detection unit 136 compares an operation result value with respect to the a phase obtained by the mobile window operation unit 134 with a first reference value that is preset and determines whether the operation result value of the a phase is smaller than the first reference value (S201).

As a result of the determining of operation S201, when the operation result value with respect to the a phase is smaller than the preset first reference value, the cable state detection unit 136 determines that an a-phase cable of the power cable 120 is abnormal (S202).

Also, the cable state detection unit 136 compares an operation result value with respect to the b phase obtained by the mobile window operation unit 134 with a second reference value that is preset and determines whether the operation result value of the b phase is smaller than the second reference value (S203).

As a result of the determining of operation S203, when the operation result value with respect to the b phase is smaller than the preset second reference value, the cable state detection unit 136 determines that a b-phase cable of the power cable 120 is abnormal (S204).

Also, the cable state detection unit 136 compares an operation result value with respect to the c phase obtained by the mobile window operation unit 134 with a third reference value that is preset and determines whether the operation result value of the c phase is smaller than the third reference value (S205).

As a result of the determining of operation S205, when the operation result value with respect to the c phase is smaller than the preset third reference value, the cable state detection unit 136 determines that a c-phase cable of the power cable 120 is abnormal (S206).

According to the embodiment, since it is possible to detect a disconnection of the power cable 120 in an aspect of software in real time, it is possible not only to provide advantageous effects in an aspect of price but also to prevent malfunctions that may occur due to external causes, thereby improving safety of a driver.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

**Claims**

1. A method of detecting a state of a power cable of an inverter system comprising an inverter (110), the method comprising:

   obtaining phase-current values supplied to a motor through the power cable according to a preset period (S101);
   calculating absolute values ($|Ias|$, $|Ibs|$, $|Ics|$) based on the obtained phase-current values (S102);
   generating a mobile window (w) having a certain size with respect to the phase-current values obtained for each preset period and obtaining a mobile window operation value (D) by using the absolute values of the phase-current values included in the generated mobile window (S103);
   comparing the obtained mobile window operation value with a preset reference value (S106); and
   detecting whether the power cable is abnormal, according to a result of the comparing (S107),
   **characterized in that**
   at a point in time that the inverter (110) is initially operating, the mobile window operation value is obtained by using a mean value ($D_{average}$) of the absolute values of the phase-current values; and
   at a point in time that the inverter (110) is stabilizing, the mobile window operation value is obtained by using any one of:

      - an integral value ($D_{integ}$) of the absolute values of the phase-current values;
      - a total sum ($D_{sum}$) of the absolute values of the phase-current values; and
      - a total sum ($D_{sum}$) of the absolute values of the phase-current values, the absolute values being added with a weighted factor.

2. The method of claim 1, wherein the power cable is a three-phase power cable,
   wherein the obtaining of the phase-current values comprises obtaining an a-phase current value, a b-phase current value, and a c-current value with respect to three phases, respectively, and
   wherein the detecting of whether the power cable is abnormal comprises detecting whether an a-phase power cable, a b-phase power cable, and a c-phase cable included in the three-phase power cable are abnormal, respectively.

3. The method of one of claims 1 to 2, wherein the detecting of whether the power cable is abnormal comprises:

   detecting that the power cable is normal when the obtained mobile window operation value is the preset reference value or more; and
   detecting that the power cable is abnormal when the obtained mobile window operation value is smaller than the preset reference value.

4. The method of one of claims 1 to 3, further comprising determining whether a present state of the inverter system satisfies preset preconditions,
   wherein the detecting of whether the power cable is abnormal is performed when the present state of the inverter system satisfies the preset preconditions, and
wherein the preconditions comprises any one of:

> a condition, in which the period of the phase current is a certain value or less;
> a condition, in which the inverter operates according to a gear stage for performing a pulse width modulation (PWM) control; and
> a condition, in which an instruction comprising at least one of torque, velocity, and currents is a certain value or more.

5. The method of one of claims 1 to 4, further comprising, when the mobile window operation value is obtained, moving a location of the mobile window to the right with a certain interval and obtaining a mobile window operation value of the moved mobile window.

6. An inverter system comprising:

> an inverter (110) configured to convert a direct current (DC) power supplied from a battery into an alternating current (AC) power;
> a power cable (120) connected to the inverter (110) and configured to supply the AC power to a motor; and
> a controller (130) configured to:
>
> > obtain phase-current values supplied to the motor through the power cable according to a preset period;
> > calculate absolute values ($|Ias|$, $|Ibs|$, $|Ics|$) based on the obtained phase-current values;
> > obtain a mobile window operation value (D) by using the absolute values included in a mobile window (w) having a certain size among the absolute values obtained for each preset period; and
> > detect a state of the power cable by using the obtained mobile window operation value,
>
> **characterized in that**
> at a point in time that the inverter (110) is initially operating, the controller is configured to obtain the mobile window operation value by using a mean value ($D_{average}$) of absolute values of the phase-current values; and
> at a point in time that the inverter (110) is stabilizing, the controller is configured to obtain the mobile window operation value by using any one of:
>
> > - an integral value ($D_{integ}$) of the absolute values of the phase-current values;
> > - a total sum ($D_{sum}$) of the absolute values of the phase-current values; and
> > - a total sum ($D_{sum}$) of the absolute values of the phase-current values, the absolute values being added with a weighted factor.

7. The inverter system of claim 6, wherein the power cable (120) is a three-phase power cable, wherein the phase-current value comprises an a-phase current value, a b-phase current value, and a c-current value with respect to three phases, respectively, and wherein the controller (130) detects whether an a-phase power cable, a b-phase power cable, and a c-phase cable included in the three-phase power cable are abnormal, respectively.

8. The inverter system of one of claims 6 to 7, wherein the controller (130) detects that the power cable (120) is normal when the obtained mobile window operation value is the preset reference value or more, and wherein the controller (130) detects that the power cable (120) is abnormal when the obtained mobile window operation value is smaller than the preset reference value.

9. The inverter system of one of claims 6 to 8, wherein the controller (130) detects whether the power cable (120) is abnormal when satisfying any one of a condition, in which the period of the phase current is a certain value or less, a condition, in which the inverter (110) operates according to a gear stage for performing a pulse width modulation (PWM) control, and a case, in which an instruction comprising at least one of torque, velocity, and currents is a certain value or more.

10. The inverter system of one of claims 6 to 9, wherein the controller (130), when the mobile window operation value is obtained, moves a location of the mobile window to the right with a certain interval and obtains a mobile window operation value of the moved mobile window.

**Patentansprüche**

1. Verfahren zum Erkennen eines Zustands eines Stromkabels eines Wechselrichtersystems, das einen Wechselrichter (110) umfasst, das Verfahren umfassend:

   Erhalten von Phasenstromwerten, die einem Motor über das Stromkabel gemäß einer voreingestellten Periode zugeführt werden (S101);
   Berechnen von Absolutwerten ($|Ias|$, $|Ibs|$, $|Ics|$) basierend auf den erhaltenen Phasenstromwerten (S102);
   Erzeugen eines mobilen Fensters (w) mit einer bestimmten Größe in Bezug auf die Phasenstromwerte, die für jede voreingestellte Periode erhalten werden, und Erhalten eines Operationswertes (D) des mobilen Fensters unter Verwendung der Absolutwerte der Phasenstromwerte, die in dem erzeugten mobilen Fenster enthalten sind (S103);
   Vergleichen des erhaltenen Operationswertes des mobilen Fensters mit einem voreingestellten Referenzwert (S106); und
   Erkennen, ob das Stromkabel abnormal ist, gemäß einem Ergebnis des Vergleichens (S107),
   **dadurch gekennzeichnet, dass** zu einem Zeitpunkt, zu dem der Wechselrichter (110) anfänglich arbeitet, der Operationswert des mobilen Fensters unter Verwendung eines Mittelwerts ($D_{Durchschnitt}$) der Absolutwerte der Phasenstromwerte erhalten wird; und
   zu einem Zeitpunkt, zu dem der Wechselrichter (110) stabilisiert, der Operationswert des mobilen Fensters erhalten wird, indem beliebiges verwendet wird aus:
   einem Integralwert ($D_{integ}$) der Absolutwerte der Phasenstromwerte; einer Gesamtsumme ($D_{sum}$) der Absolutwerte der Phasenstromwerte; und einer Gesamtsumme ($D_{sum}$) der Absolutwerte der Phasenstromwerte, wobei die Absolutwerte mit einem gewichteten Faktor addiert werden.

2. Verfahren nach Anspruch 1, wobei das Stromkabel ein dreiphasiges Stromkabel ist,
   wobei das Erhalten der Phasenstromwerte das Erhalten eines a-Phasen-Stromwerts, eines b-Phasen-Stromwerts und eines c-Stromwerts in Bezug auf jeweils drei Phasen umfasst, und
   wobei das Erkennen, ob das Stromkabel anormal ist, das Erkennen umfasst, ob ein a-Phasen-Stromkabel, ein b-Phasen-Stromkabel und ein c-Phasen-Kabel, die in dem dreiphasigen Stromkabel enthalten sind, jeweils abnormal sind.

3. Verfahren nach einem der Ansprüche 1 bis 2, wobei das Erkennen, ob das Stromkabel abnormal ist, umfasst:

   Erkennen, dass das Stromkabel normal ist, wenn der erhaltene Operationswert des mobilen Fensters der voreingestellte Referenzwert oder höher ist; und
   Erkennen, dass das Stromkabel abnormal ist, wenn der erhaltene Operationswert des mobilen Fensters kleiner als der voreingestellte Referenzwert ist.

4. Verfahren nach einem der Ansprüche 1 bis 3, ferner umfassend das Ermitteln, ob ein gegenwärtiger Zustand des Wechselrichtersystems voreingestellte Voraussetzungen erfüllt,
   wobei das Erkennen, ob das Stromkabel abnormal ist, durchgeführt wird, wenn der gegenwärtige Zustand des Wechselrichtersystems die voreingestellten Voraussetzungen erfüllt, und
   wobei die Voraussetzungen beliebige umfassen aus:

   einem Zustand, in dem die Periode des Phasenstroms ein bestimmter Wert oder weniger ist; einem Zustand, in dem der Wechselrichter gemäß einer Getriebestufe zum Durchführen einer Pulsweitenmodulationssteuerung (PWM-Steuerung) arbeitet; und
   einem Zustand, in dem eine Anweisung, die mindestens eines von Drehmoment, Geschwindigkeit und Strömen umfasst, und
   ein bestimmter Wert oder höher ist.

5. Verfahren nach einem der Ansprüche 1 bis 4, ferner umfassend, wenn der Operationswert des mobilen Fensters erhalten wird, das Bewegen einer Position des mobilen Fensters nach rechts mit einem bestimmten Intervall und das Erhalten eines Operationswertes des mobilen Fensters des bewegten mobilen Fensters.

6. Wechselrichtersystem, umfassend:

   einen Wechselrichter (110), der so konfiguriert ist, dass er eine von einer Batterie gelieferte Gleichstromleistung (DC-Leistung) in eine Wechselstromleistung (AC-Leistung) umwandelt;
ein Stromkabel (120), das mit dem Wechselrichter (110) verbunden und so konfiguriert ist, dass es die Wechselstrom-Leistung an einen Motor liefert; und
eine Steuereinheit (130), die konfiguriert ist zum:

Erhalten von Phasenstromwerten, die dem Motor über das Stromkabel gemäß einer voreingestellten Periode zugeführt werden;
Berechnen von Absolutwerten ($|Ias|$, $|Ibs|$, $|Ics|$) basierend auf den erhaltenen Phasenstromwerten;
Erhalten eines Operationswertes (D) eines mobilen Fensters unter Verwendung der Absolutwerte, die in einem mobilen Fenster (w) mit einer bestimmten Größe unter den Absolutwerten, die für jede voreingestellte Periode erhalten werden, enthalten sind; und
Erkennen eines Zustands des Stromkabels unter Verwendung des erhaltenen Operationswertes des mobilen Fensters,
**dadurch gekennzeichnet, dass**
zu einem Zeitpunkt, zu dem der Wechselrichter (110) anfänglich arbeitet, die Steuereinheit so konfiguriert ist, dass sie den Operationswert des mobilen Fensters unter Verwendung eines Mittelwerts ($D_{Durchschnitt}$) von Absolutwerten der Phasenstromwerte erhält; und
zu einem Zeitpunkt, zu dem der Wechselrichter (110) stabilisiert ist, die Steuereinheit so konfiguriert ist, dass sie den Operationswert des mobilen Fensters unter Verwendung von beliebigen aus einem Integralwert ($D_{integ}$) der Absolutwerte der Phasenstromwerte; einer Gesamtsumme ($D_{sum}$) der Absolutwerte der Phasenstromwerte; und einer Gesamtsumme ($D_{sum}$) der Absolutwerte der Phasenstromwerte erhält, wobei die Absolutwerte mit einem gewichteten Faktor addiert werden.

7. Wechselrichtersystem nach Anspruch 6, wobei das Stromkabel (120) ein dreiphasiges Stromkabel ist,
wobei der Phasenstromwert einen a-Phasen-Stromwert, einen b-Phasen-Stromwert und einen c-Stromwert in Bezug auf jeweils drei Phasen umfasst, und
wobei die Steuereinheit (130) erkennt, ob ein a-Phasen-Stromkabel, ein b-Phasen-Stromkabel und ein c-Phasen-Kabel, die in dem dreiphasigen Stromkabel enthalten sind, jeweils abnormal sind.

8. Wechselrichtersystem nach einem der Ansprüche 6 bis 7,
wobei die Steuereinheit (130) erkennt, dass das Stromkabel (120) normal ist, wenn der erhaltene Operationswert des mobilen Fensters der voreingestellte Referenzwert oder höher ist, und
wobei die Steuereinheit (130) erkennt, dass das Stromkabel (120) abnormal ist, wenn der erhaltene Operationswert des mobilen Fensters kleiner als der voreingestellte Referenzwert ist.

9. Wechselrichtersystem nach einem der Ansprüche 6 bis 8,
wobei die Steuereinheit (130) erkennt, ob das Stromkabel (120) abnormal ist, wenn beliebiges aus einem Zustand, in dem die Periode des Phasenstroms ein bestimmter Wert oder weniger ist, einem Zustand, in dem der Wechselrichter (110) gemäß einer Getriebestufe arbeitet, um eine Pulsweitenmodulationssteuerung (PWM-Steuerung) durchzuführen, und einem Fall, in dem eine Anweisung, die mindestens eines von Drehmoment, Geschwindigkeit und Strömen umfasst, ein bestimmter Wert oder höher ist.

10. Wechselrichtersystem nach einem der Ansprüche 6 bis 9,
wobei die Steuereinheit (130), wenn der Operationswert des mobilen Fensters erhalten wird, eine Position des mobilen Fensters nach rechts mit einem bestimmten Intervall bewegt und einen Operationswert des mobilen Fensters des bewegten mobilen Fensters erhält.

**Revendications**

1. Procédé de détection d'un état d'un câble d'alimentation d'un système d'onduleur comprenant un onduleur (110), le procédé comprenant :

l'obtention de valeurs de courant de phase fournies à un moteur par le câble d'alimentation selon une période prédéfinie (S101) ;
le calcul de valeurs absolues ($|Ias|$, $|Ibs|$, $|Ics|$) sur la base des valeurs de courant de phase obtenues (S102) ;
la génération d'une fenêtre mobile (w) ayant une certaine taille par rapport aux valeurs de courant de phase obtenues pour chaque période prédéfinie et l'obtention d'une valeur de fonctionnement de fenêtre mobile (D) en utilisant les valeurs absolues des valeurs de courant de phase incluses dans la fenêtre mobile générée (S103) ;

la comparaison de la valeur de fonctionnement de fenêtre mobile obtenue avec une valeur de référence prédéfinie (S106) ; et

le fait de détecter si le câble d'alimentation est anormal, en fonction d'un résultat de la comparaison (S107), **caractérisé en ce que**

à un moment auquel l'onduleur (110) fonctionne initialement, la valeur de fonctionnement de fenêtre mobile est obtenue en utilisant une valeur moyenne ($D_{moyenne}$) des valeurs absolues des valeurs de courant de phase ; et

à un moment auquel l'onduleur (110) se stabilise, la valeur de fonctionnement de fenêtre mobile est obtenue en utilisant l'un quelconque de :

- une valeur intégrale ($D_{intég}$) des valeurs absolues des valeurs de courant de phase ;
- une somme totale ($D_{somme}$) des valeurs absolues des valeurs de courant de phase ; et
- une somme totale ($D_{somme}$) des valeurs absolues des valeurs de courant de phase, les valeurs absolues étant additionnées avec un facteur de pondération.

2. Procédé selon la revendication 1, dans lequel le câble d'alimentation est un câble d'alimentation triphasé, dans lequel l'obtention des valeurs de courant de phase comprend l'obtention d'une valeur de courant de phase a, d'une valeur de courant de phase b, et d'une valeur de courant c par rapport aux trois phases, respectivement, et

dans lequel le fait de détecter si le câble d'alimentation est anormal comprend le fait de détecter si un câble d'alimentation de phase a, un câble d'alimentation de phase b et un câble de phase c inclus dans le câble d'alimentation triphasé sont respectivement anormaux.

3. Procédé selon l'une des revendications 1 à 2, dans lequel le fait de détecter si le câble d'alimentation est anormal comprend :

la détection que le câble d'alimentation est normal lorsque la valeur de fonctionnement de fenêtre mobile obtenue est la valeur de référence prédéfinie ou plus ; et

la détection que le câble d'alimentation est anormal lorsque la valeur de fonctionnement de fenêtre mobile est inférieure à la valeur de référence prédéfinie.

4. Procédé selon l'une des revendications 1 à 3, comprenant en outre le fait de déterminer si un état présent du système d'onduleur satisfait des conditions préalables prédéfinies,

dans lequel le fait de détecter si le câble d'alimentation est anormal est réalisé lorsque l'état présent du système d'onduleur satisfait les conditions préalables prédéfinies, et

dans lequel les conditions préalables comprennent l'une quelconque de :

une condition, dans laquelle la période du courant de phase est une certaine valeur ou moins ;

une condition, dans laquelle l'onduleur fonctionne selon un étage d'engrenage pour réaliser une commande de modulation de largeur d'impulsions (MLI) ; et

une condition, dans laquelle une instruction comprenant au moins l'un parmi un couple, une vitesse et des courants est une certaine valeur ou plus.

5. Procédé selon l'une quelconque des revendications 1 à 4, comprenant en outre, lorsque la valeur de fonctionnement de fenêtre mobile est obtenue, le déplacement d'un emplacement de la fenêtre mobile vers la droite avec un certain intervalle et l'obtention d'une valeur de fonctionnement de fenêtre mobile de la fenêtre mobile déplacée.

6. Système d'onduleur comprenant :

un onduleur (110) configuré pour convertir une puissance de courant continu (CC) fournie par une batterie en une puissance de courant alternatif (CA) ;

un câble d'alimentation (120) connecté à l'onduleur (110) et configuré pour fournir la puissance CA à un moteur ; et

un dispositif de commande (130) configuré pour :

obtenir des valeurs de courant de phase fournies à un moteur par le câble d'alimentation selon une période prédéfinie ;

calculer des valeurs absolues (|Ias|, |Ibs|, |Ics|) sur la base des valeurs de courant de phase obtenues ;

obtenir une valeur de fonctionnement de fenêtre mobile (D) en utilisant les valeurs absolues incluses dans une fenêtre mobile (w) ayant une certaine taille parmi les valeurs absolues obtenues pour chaque période prédéfinie ; et

détecter un état du câble d'alimentation en utilisant la valeur de fonctionnement de fenêtre mobile obtenue,

**caractérisé en ce que**

à un moment auquel l'onduleur (110) fonctionne initialement, le dispositif de commande est configuré pour obtenir la valeur de fonctionnement de fenêtre mobile en utilisant une valeur moyenne ($D_{moyenne}$) des valeurs absolues des valeurs de courant de phase ; et

à un moment auquel l'onduleur (110) se stabilise, le dispositif de commande est configuré pour obtenir la valeur de fonctionnement de fenêtre mobile en utilisant l'une quelconque de :

- une valeur intégrale ($D_{intég}$) des valeurs absolues des valeurs de courant de phase ;
- une somme totale ($D_{somme}$) des valeurs absolues des valeurs de courant de phase ; et
- une somme totale ($D_{somme}$) des valeurs absolues des valeurs de courant de phase, les valeurs absolues étant additionnées avec un facteur de pondération.

7. Système d'onduleur selon la revendication 6, dans lequel le câble d'alimentation (120) est un câble d'alimentation triphasé,

dans lequel la valeur de courant de phase comprend une valeur de courant de phase a, une valeur de phase b, et d'une valeur de courant c par rapport aux trois phases, respectivement, et

dans lequel le dispositif de commande (130) détecte si un câble d'alimentation de phase a, un câble d'alimentation de phase b et un câble de phase c inclus dans le câble d'alimentation triphasé sont respectivement anormaux.

8. Système d'onduleur selon l'une des revendications 6 à 7, dans lequel le dispositif de commande (130) détecte que le câble d'alimentation (120) est normal lorsque la valeur de fonctionnement de fenêtre mobile obtenue est la valeur de référence prédéfinie ou plus, et

dans lequel le dispositif de commande (130) détecte que le câble d'alimentation (120) est anormal lorsque la valeur de fonctionnement de fenêtre mobile est inférieure à la valeur de référence prédéfinie.

9. Système d'onduleur selon l'une des revendications 6 à 8, dans lequel le dispositif de commande (130) détecte si le câble d'alimentation (120) est anormal lorsqu'il satisfait à l'une quelconque d'une condition, dans laquelle la période du courant de phase est une certaine valeur ou moins, d'une condition, dans laquelle l'onduleur (110) fonctionne selon un étage d'engrenage pour réaliser une commande de modulation de largeur d'impulsions (MLI), et d'un cas, dans lequel une instruction comprenant au moins l'un parmi un couple, une vitesse et des courants est une certaine valeur ou plus.

10. Système d'onduleur selon l'une quelconque des revendications 6 à 9, dans lequel le dispositif de commande (130), lorsque la valeur de fonctionnement de fenêtre mobile est obtenue, déplace un emplacement de la fenêtre mobile vers la droite avec un certain intervalle et obtient une valeur de fonctionnement de fenêtre mobile de la fenêtre mobile déplacée.

[FIG. 1]

[FIG. 2]

MOTOR

CONTROLLER

[FIG. 3]

130

```
┌─────────────────────────────────────────┐
│  ┌──────────────────────────────────┐    │
│  │   PHASE-CURRENT OBTAIN UNIT       ├──── 132
│  └──────────────────────────────────┘    │
│                  ↕                        │
│  ┌──────────────────────────────────┐    │
│  │   MOBILE WINDOW OPERATION UNIT    ├──── 134
│  └──────────────────────────────────┘    │
│                  ↕                        │
│  ┌──────────────────────────────────┐    │
│  │   CABLE STATE DETECTION UNIT      ├──── 136
│  └──────────────────────────────────┘    │
└─────────────────────────────────────────┘
```

[FIG. 4]

[FIG. 5]

[FIG. 6]

```
                    ┌─────────────┐
                    │    START    │
                    └──────┬──────┘
                           │
    ┌──────────────────────┤
    │                      ▼
    │   ┌──────────────────────────────────────┐
    │   │       OBTAIN PHASE CURRENT           │──S101
    │   └──────────────────┬───────────────────┘
    │                      ▼
    │   ┌──────────────────────────────────────┐
    │   │       CALCULATE ABSOLUTE VALUE        │──S102
    │   │       OF OBTAINED PHASE CURRENT       │
    │   └──────────────────┬───────────────────┘
    │                      ▼
    │   ┌──────────────────────────────────────┐
    │   │ ARITHMETICALLY OPERATE MOBILE WINDOW  │
    │   │ WITH RESPECT TO ABSOLUTE VALUE OF     │──S103
    │   │ OBTAINED PHASE CURRENT WHILE LIMITING │
    │   │ OPERATION RESULT TO PREVENT OVERFLOW  │
    │   └──────────────────┬───────────────────┘
    │                      ▼           S104
    │ NO       ◇───────────────────────◇
    └─────────◇  DOES CERTAIN TIME PASS? ◇
              ◇───────────┬─────────────◇
                          │ YES
                          ▼           S105
                 ◇────────────────────◇      NO
                ◇ ARE PRECONDITIONS    ◇──────────┐
                ◇    SATISFIED?        ◇          │
                 ◇────────┬───────────◇           │
                          │ YES                   │
                          ▼                       │
          ┌──────────────────────────────┐        │
          │  COMPARE OPERATION RESULT     │──S106  │
          │  VALUE WITH PRESET REFERENCE  │        │
          │  VALUE                        │        │
          └──────────────┬───────────────┘        │
                         │ YES                     │
                         ▼          S107           │
                ◇──────────────────◇    NO         │
               ◇ OPERATION RESULT   ◇──────────────┤
               ◇ VALUE < REFERENCE  ◇              │
               ◇     VALUE?         ◇              │
                ◇────────┬─────────◇               │
                         │                         │
                         ▼                         │
          ┌──────────────────────────────┐        │
          │  DETECT DISCONNECTION OF      │──S108  │
          │      POWER CABLE              │        │
          └──────────────┬───────────────┘        │
                         ◄─────────────────────────┘
                         ▼
                  ┌─────────────┐
                  │     END     │
                  └─────────────┘
```

[FIG. 7]

```
                              ( START )
                                 |
        +------------------------+------------------------+
        |                        |                        |
        v                        v                        v
       /S201                    /S203                    /S205
      /      \                 /      \                 /      \
     / a-PHASE \              / b-PHASE \              / c-PHASE \
NO  / OPERATION \        NO  / OPERATION \        NO  / OPERATION \
<---< VALUE       >     <---< VALUE       >     <---< VALUE       >
    \ <FIRST    /           \ <SECOND   /           \ <THIRD    /
     \REFERENCE/             \REFERENCE/             \REFERENCE/
      \VALUE? /               \VALUE? /               \VALUE? /
       \    /                  \    /                  \    /
        |YES    S202            |YES    S204            |YES    S206
        v                        v                        v
  +--------------+         +--------------+         +--------------+
  | DETECT       |         | DETECT       |         | DETECT       |
  | ABNORMALITY  |         | ABNORMALITY  |         | ABNORMALITY  |
  | OF a PHASE   |         | OF b PHASE   |         | OF c PHASE   |
  | OF POWER     |         | OF POWER     |         | OF POWER     |
  | CABLE        |         | CABLE        |         | CABLE        |
  +--------------+         +--------------+         +--------------+
        |                        |                        |
        +------------------------+------------------------+
        |
        v
     ( END )
```

**EP 2 829 886 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H06245301 B